# EUROPÄISCHE PATENTSCHRIFT

(11) **EP 4 046 276 B1**
(45) Veröffentlichungstag und Bekanntmachung des Hinweises auf die Patenterteilung: **25.12.2024**
(21) Anmeldenummer: 20793307.8
(22) Anmeldetag: 14.10.2020
(51) Int. Cl.: H03K 17/12, H03K 17/18

(54) **SYSTEM UND VERFAHREN ZUM ERKENNEN VON NICHT SCHALTENDEN HALBLEITERSCHALTERN**
SYSTEM AND METHOD FOR IDENTIFYING NON-SWITCHING SEMICONDUCTOR SWITCHES
SYSTÈME ET PROCÉDÉ D'IDENTIFICATION DE COMMUTATEURS À SEMI-CONDUCTEUR SANS COMMUTATION

(30) Priorität: 15.10.2019 DE 102019127733
(43) Veröffentlichungstag der Anmeldung: 24.08.2022
(73) Patentinhaber: LEONI Bordnetz-Systeme GmbH, 97318 Kitzingen (DE)
(72) Erfinder: EBERT, Matthias, 97337 Dettelbach (DE); KOCH, Wolfgang, 97320 Buchbrunn (DE); ROESLER, Martin, 90574 Rosstal (DE)
(74) Vertreter: Frenkel, Matthias Alexander
(86) Internationale Anmeldenummer: PCT/EP2020/078905
(87) Internationale Veröffentlichungsnummer: WO 2021/074225

(56) Entgegenhaltungen:
- EP-A1- 2 843 837
- WO-A1-2010/087745
- US-A- 5 051 603
- US-A1- 2017 279 443

## Beschreibung

Die vorliegende Erfindung betrifft im Allgemeinen das Erkennen eines nicht schaltenden Halbleiterschalters von parallel geschalteten Halbleiterschaltern. Im Speziellen betrifft die vorliegende Erfindung ein System sowie ein Verfahren zum Erkennen eines nicht schaltenden Halbleiterschalters von mindestens zwei parallel geschalteten Halbleiterschaltern.

In elektronischen Leistungsverteilern, insbesondere in solchen mit hohen Anforderungen an die funktionale Sicherheit, ist es von besonderer Bedeutung, dass der Gesundheitszustand, auch oftmals als State of Health (SoH) bezeichnet, der verwendeten Leistungshalbleiter zu möglichst jedem Zeitpunkt bekannt ist. Hierfür ist es wichtig zu wissen, ob ein als Schalter dienender Leistungshalbleiter während des laufenden Betriebs in der Lage ist, auf jeden Fall sicher schalten, insbesondere abschalten, zu können. Ist dies nicht möglich, so besteht nur die Möglichkeit dem Leistungshalbleiter einen zweiten Leistungshalbleiter in Reihe zu schalten. Dies erhöht jedoch die Kosten, den Platzbedarf und die Verlustleistung des Kanals. Ferner wird durch die Reihenschaltung eines zweiten Leistungshalbleiters lediglich die Wahrscheinlichkeit eines Fehlversagens statistisch gesenkt. Eine tatsächliche Überprüfung und/oder Diagnose eines erfolgreichen Schaltvorgangs des Halbleiters ist nur durch ein Abschalten des Halbleiters möglich.

Die DE 43 01 605 C1 offenbart ein Verfahren und eine Anordnung zum Überwachen des Ein- und Ausschaltens eines steuerbaren Leistungshalbleiterbauelements in einer leistungselektronischen Schaltung. Bei einem Ansteuerungssignal zur Einschaltung des Leistungshalbleiterbauelements werden aus Pegelwechseln des die Gate-Elektrode beaufschlagenden Signals und den Pegelwechseln an einer Ausgangselektrode beim Umschalten des Leistungshalbleiterbauelements Zählsignale gebildet. Die Zählsignale werden in einem ersten Zähler aufsummiert und mit einem der einwandfreien Arbeitsweise des Leistungshalbleiterbauelements zugeordneten, vorgegebenen Zählwert verglichen. Bei einem Unterschied zwischen der Summe der Zählsignale und dem vorgegebene Zählwert wird ein Fehler gemeldet.

Dieses Verfahren und die zugehörige Anordnung sind zumindest insofern nachteilig, als dass sie nur bei ständig schaltenden Schaltern funktionieren. Im statischen Betrieb kann das System nicht unmittelbar einen Fehler diagnostizieren. Das Verfahren und die Anordnung der DE 43 01 605 C1 sind daher insbesondere im statischen Betrieb für die Fehlererkennung nicht zuverlässig genug.

Ein System und ein Verfahren zum Erkennen eines nicht schaltenden Halbleiterschalters nach dem Oberbegriff der Ansprüche 1 und 10 sind aus dem WO 2010/087745 A1 bekannt. Es besteht daher ein Bedarf nach einem zuverlässigen und genauen Erkennen nicht schaltender Halbleiterschalter. Das Erkennen sollte insbesondere möglich sein, ohne dabei eine dazugehörige Last abschalten zu müssen.

Gemäß einem ersten Aspekt der Erfindung wird ein System zum Erkennen eines nicht schaltenden Halbleiterschalters nach Anspruch 1 bereitgestellt.

Anders ausgedrückt ist die Ermittlungseinheit ausgebildet, basierend auf dem (zeitlichen) Verlauf der elektrischen Größe des ersten Halbleiterschalters und dem (zeitlichen) Verlauf der elektrischen Größe des zweiten Halbleiterschalters ein Ausgangssignal zu ermitteln, das ein Erkennen eines Fehlers beim Schalten des ersten Halbleiterschalters und/oder des zweiten Halbleiterschalters gestattet/ermöglicht. Das System zum Erkennen eines nicht schaltenden Halbleiterschalters kann demnach alternativ auch als System zum Erkennen eines Fehlers beim Schalten eines Halbleiterschalters bezeichnet werden. Der Fehler kann beispielsweise manuell erkannt werden, indem das ermittelte Ausgangssignal oder ein von dem ermittelten Ausgangssignal abgeleitetes Signal betrachtet wird. Alternativ kann der Fehler automatisiert von einer Erkennungskomponente anhand des ermittelten Ausgangssignals oder eines von dem ermittelten Ausgangssignal abgeleiteten Signals erkannt werden.

Bei der elektrischen Größe kann es sich um einen elektrischen Strom, eine elektrische Spannung, einen elektrischen Widerstand und/oder eine elektrische Leistung handeln. Der Verlauf ist insbesondere ein zeitlicher Verlauf.

Der erste Halbleiterschalter kann einen geöffneten/offenen Schaltzustand und einen geschlossenen Schaltzustand einnehmen. Der erste Halbleiterschalter kann mittels des ersten Ansteuersignals von dem offenen Schaltzustand in den geschlossenen Schaltzustand überführt werden und umgekehrt. Der zweite Halbleiterschalter kann einen geöffneten/offenen Schaltzustand und einen geschlossenen Schaltzustand einnehmen. Der zweite Halbleiterschalter kann mittels des zweiten Ansteuersignals von dem offenen Schaltzustand in den geschlossenen Schaltzustand überführt werden und umgekehrt.

Der erste und/oder zweite Halbleiterschalter kann/können Teil des Systems sein oder kann/können, als von dem System separat anzusehende Komponenten, von dem System überwacht werden. Anders ausgedrückt kann das System den ersten und/oder zweiten Halbleiterschalter aufweisen oder den ersten und/oder zweiten Halbleiterschalter als externe Einheit(en) überwachen.

Auch wenn hierin von einem ersten und einem zweiten Halbleiterschalter gesprochen wird, so ist die Erfindung nicht auf die Erkennung eines nicht schaltenden Halbleiterschalters von genau zwei parallel geschalteten Halbleiterschaltern begrenzt. Beispielsweise können auch drei oder mehr als drei Halbleiterschalter parallel geschaltet sein. Anders ausgedrückt wird gemäß dem ersten Aspekt der Erfindung ein System zum Erkennen eines nicht schaltenden Halbleiterschalters von mindestens zwei parallel geschalteten Halbleiterschaltern bereitgestellt.

Beispielsweise können der erste Halbleiterschalter, der zweite Halbleiterschalter und mindestens ein dritter Halbleiterschalter zueinander parallel geschaltet sein. In diesem Fall kann das System einen nicht schaltenden Halbleiterschalter aus dem ersten Halbleiterschalter, dem zweiten Halbleiterschalter und dem mindestens einen dritten Halbleiterschalter erkennen. Der erste und/oder zweite und/oder mindestens eine dritte Halbleiterschalter kann/können Teil des Systems sein oder kann/können, als von dem System separat anzusehende Komponenten, von dem System überwacht werden. Anders ausgedrückt kann das System den ersten und/oder zweiten und/oder mindestens einen dritten Halbleiterschalter aufweisen oder den ersten und/oder zweiten und/oder mindestens einen dritten Halbleiterschalter als externe Einheit(en) überwachen.

Falls der erste und/oder zweite Halbleiterschalter sich nicht mehr von einem offenen in einen geschlossenen Zustand überführen ließe, kann mittels des mindestens einen dritten Halbleiterschalters eine Art Notlaufbetrieb gewährleistet werden. Ohne den mindestens einen dritten Halbleiterschalter würde in dem vorgenannten Fall eine Last zumindest kurzzeitig abschalten.

Das System kann Teil eines Leistungsverteilungssystems, wie z.B. eines Leistungsverteilungssystems mit hohen Anforderungen an die funktionale Sicherheit und/oder Zuverlässigkeit, sein. Bei Leistungsverteilungssystemen im Allgemeinen und bei solchen mit hohen Sicherheitsanforderungen im Speziellen ist es wichtig, die Funktionsfähigkeit der verwendeten Halbleiterschalter erkennen und/oder verifizieren zu können, insbesondere ohne dabei eine Last, die bevorzugt nach einem Haltleiterschalter geschaltet ist, im laufenden Betrieb zu beeinträchtigen.

Die erste Erfassungskomponente kann einen ersten Messverstärker aufweisen oder als erster Messverstärker ausgebildet sein. Der erste Messverstärker kann beispielsweise ausgebildet sein, als Verlauf der elektrischen Größe des ersten Halbleiterschalters einen Verlauf eines elektrischen Stroms durch einen zu dem ersten Halbleiterschalter in Reihe geschalteten ersten Strommesswiderstand zu ermitteln. Der erste Messverstärker kann beispielsweise als Spannungsmessgerät dazu ausgebildet sein, als Verlauf der elektrischen Größe des ersten Halbleiterschalters einen Verlauf einer an einem zu dem ersten Halbleiterschalter in Reihe geschalteten ersten Strommesswiderstand abfallenden elektrischen Spannung zu ermitteln. Aus dieser elektrischen Spannung kann anhand eines bekannten Widerstandswerts auf den elektrischen Strom durch den ersten Strommesswiderstand geschlossen werden. Wird beispielsweise ein elektrischer Strom als elektrische Größe ermittelt oder aus der Spannung abgeleitet, entspricht, aufgrund der Reihenschaltung, der elektrische Strom durch den ersten Strommesswiderstand dem elektrischen Strom durch den ersten Halbleiterschalter, beispielsweise einem Drainstrom durch den ersten Halbleiterschalter, falls der erste Halbleiterschalter als Feldeffekttransistor ausgebildet ist.

Die zweite Erfassungskomponente kann einen zweiten Messverstärker aufweisen oder als zweiter Messverstärker ausgebildet sein. Der zweite Messverstärker kann beispielsweise ausgebildet sein, als Verlauf der elektrischen Größe des zweiten Halbleiterschalters einen Verlauf eines elektrischen Stroms durch einen zu dem zweiten Halbleiterschalter in Reihe geschalteten zweiten Strommesswiderstand zu ermitteln. Der zweite Messverstärker kann beispielsweise als Spannungsmessgerät dazu ausgebildet sein, als Verlauf der elektrischen Größe des zweiten Halbleiterschalters einen Verlauf einer an einem zu dem zweiten Halbleiterschalter in Reihe geschalteten zweiten Strommesswiderstand abfallenden elektrischen Spannung zu ermitteln. Aus dieser elektrischen Spannung kann anhand eines bekannten Widerstandswerts auf den elektrischen Strom durch den zweiten Strommesswiderstand geschlossen werden. Wird beispielsweise ein elektrischer Strom als elektrische Größe ermittelt oder aus der Spannung abgeleitet, entspricht, aufgrund der Reihenschaltung, der elektrische Strom durch den zweiten Strommesswiderstand dem elektrischen Strom durch den zweiten Halbleiterschalter, beispielsweise einem Drainstrom durch den zweiten Halbleiterschalter, falls der zweite Halbleiterschalter als Feldeffekttransistor ausgebildet ist.

Der erste und/oder zweite Strommesswiderstand kann/können als Shunt ausgebildet sein oder einen Shunt aufweisen. Demnach kann/können der erste und/oder zweite Strommesswiderstand als ein niederohmiger elektrischer Messwiderstand, z.B. ausgestattet mit getrennten Strom- und Spannungsklemmen, ausgebildet sein oder einen solchen Messwiderstand aufweisen. Durch ein beispielsweise zu dem Shunt parallelgeschaltetes Spannungsmessgerät, als ein Beispiel für den ersten/und zweiten Messverstärker, kann ein meistens vernachlässigbar kleiner Strom abgeleitet werden.

Das von der Ermittlungseinheit ermittelte Ausgangssignal kann ein Erkennen eines Fehlers beim Schalten des ersten Halbleiterschalters von einem geschlossenen in einen offenen Schaltzustand gestatten/ermöglichen. Zusätzlich oder alternativ kann das von der Ermittlungseinheit ermittelte Ausgangssignal ein Erkennen eines Fehlers beim Schalten des zweiten Halbleiterschalters von einem geschlossenen in einen offenen Schaltzustand gestatten/ermöglichen. Anders ausgedrückt kann aus dem von der Ermittlungseinheit ermittelten Ausgangssignal abgeleitet werden, ob der erste und/oder der zweite Halbleiterschalter (korrekt) von einem geschlossenen in einen offenen Schaltzustand überführbar ist oder nicht.

Ferner kann das von der Ermittlungseinheit ermittelte Ausgangssignal ein Erkennen eines Fehlers beim Schalten des ersten Halbleiterschalters von einem offenen in einen geschlossenen Schaltzustand gestatten/ermöglichen. Zusätzlich oder alternativ kann das von der Ermittlungseinheit ermittelte Ausgangssignal ein Erkennen eines Fehlers beim Schalten des zweiten Halbleiterschalters von einem offenen in einen geschlossenen Schaltzustand gestatten/ermöglichen. Anders ausgedrückt kann aus dem von der Ermittlungseinheit ermittelten Ausgangssignal abgeleitet werden, ob der erste und/oder der zweite Halbleiterschalter (korrekt) von einem offenen in einen geschlossenen Schaltzustand überführbar ist oder nicht.

Das System kann ferner eine Erkennungskomponente aufweisen. Die Erkennungskomponente kann ausgebildet sein, den Fehler beim Schalten des ersten Halbleiterschalters basierend aus dem Ausgangssignal zu erkennen. Zusätzlich oder alternativ kann die Erkennungskomponente ausgebildet sein, den Fehler beim Schalten des zweiten Halbleiterschalters basierend aus dem Ausgangssignal zu erkennen.

Das System kann ferner ein zeitliches Verzögerungsglied, hierin auch kurz als Verzögerungsglied bezeichnet, aufweisen. Das Verzögerungsglied kann ausgebildet sein, ein Fehlersignal durch Kombination des Ausgangssignals mit einer Einschaltverzögerung zu ermitteln. Mit Hilfe des Verzögerungsglieds können durch Signallaufzeiten und Schaltverzögerungen verursachte Fehldiagnosen zumindest reduziert, wenn nicht völlig verhindert werden.

Die Ermittlungseinheit weist eine erste Vergleichskomponente und eine zweite Vergleichskomponente auf. Die erste Vergleichskomponente ist ausgebildet, einen ersten Vergleichsverlauf der elektrischen Größe des ersten Halbleiterschalters mit einem Referenzwert oder Referenzwertverlauf zu ermitteln. Der Vergleichsverlauf wird ermittelt durch Vergleichen des Verlaufs der elektrischen Größe des ersten Halbleiterschalters mit einem Verlauf eines Mittelwerts aus dem Verlauf der elektrischen Größe des ersten Halbleiterschalters und dem Verlauf der elektrischen Größe des zweiten Halbleiterschalters. Die zweite Vergleichskomponente ist ausgebildet, einen zweiten Vergleichsverlauf der elektrischen Größe des zweiten Halbleiterschalters mit einem Referenzwert oder Referenzwertverlauf zu ermitteln. Der zweite Vergleichsverlauf wird ermittelt durch Vergleichen des Verlaufs der elektrischen Größe des zweiten Halbleiterschalters mit dem Verlauf des Mittelwerts aus dem Verlauf der elektrischen Größe des ersten Halbleiterschalters und dem Verlauf der elektrischen Größe des zweiten Halbleiterschalters.

Die erste Vergleichskomponente kann einen Komparator aufweisen. Alternativ kann die erste Vergleichskomponente als Komparator ausgebildet sein. Die zweite Vergleichskomponente kann einen Komparator aufweisen. Alternativ kann die zweite Vergleichskomponente als Komparator ausgebildet sein. Der Komparator kann auch als Operationsverstärker bezeichnet werden.

Die Ermittlungseinheit kann eine erste Verknüpfungskomponente, eine zweite Verknüpfungskomponente und eine dritte Verknüpfungskomponente aufweisen. Die erste Verknüpfungskomponente kann ausgebildet sein, ein erstes Verknüpfungssignal durch Verknüpfen des ersten Vergleichsverlaufs mit dem ersten Ansteuersignal zu ermitteln. Die zweite Verknüpfungskomponente kann ausgebildet sein, ein zweites Verknüpfungssignal durch Verknüpfen des zweiten Vergleichsverlaufs mit dem zweiten Ansteuersignal zu ermitteln. Die dritte Verknüpfungskomponente kann ausgebildet sein, das Ausgangssignal durch Verknüpfen des ersten Verknüpfungssignals und des zweiten Verknüpfungssignals zu ermitteln.

Die erste Verknüpfungskomponente kann als Exklusiv-Oder-Gatter (XOR-Gatter) ausgebildet sein. Zusätzlich oder alternativ kann die zweite Verknüpfungskomponente als XOR-Gatter ausgebildet sein. Zusätzlich oder alternativ kann die dritte Verknüpfungskomponente als ODER-Gatter ausgebildet sein.

Das System kann einen Phasengenerator aufweisen. Der Phasengenerator kann ausgebildet sein, das erste Ansteuersignal zu erzeugen. Zusätzlich oder alternativ kann der Phasengenerator ausgebildet sein, das zweite Ansteuersignal zu erzeugen. Dadurch kann der Phasengenerator dazu ausgebildet sein, dafür zu sorgen, dass zumindest einer der parallel geschalteten Halbleiterschalter, d.h. des ersten Halbleiterschalters und des zweiten Halbleiterschalters und ggf. mindestens eines weiteren Halbleiterschalters, eingeschaltet ist.

Der erste Halbleiterschalter kann als Leistungshalbleiter/Leistungshalbleiterschalter ausgebildet sein. Zusätzlich oder alternativ kann der zweite Halbleiterschalter als Leistungshalbleiter/Leistungshalbleiterschalter ausgebildet sein. Das System kann in einen Leistungsverteiler eines Gesamtsystems eingebettet sein, wie z.B. Teil eines Leistungsverteilers eines Gesamtsystems sein. Das Gesamtsystem kann eine Stromversorgung (Leistungsversorgung) und mindestens einen Verbraucher aufweisen. Der Leistungsverteiler kann sich zwischen der Stromversorgung und dem mindestens einen Verbraucher befinden. Der Leistungsverteiler kann den von der Stromversorgung bereitgestellten Strom auf den mindestens einen Verbraucher verteilen. Der erste Halbleiterschalter und/oder der zweite Halbleiterschalter können in dem Leistungsverteiler angeordnet sein, um den mindestens einen Verbraucher anzuschalten (der Stromversorgung zuzuschalten) oder abzuschalten (von der Stromversorgung zu trennen).

Gemäß einem zweiten Aspekt der Erfindung wird ein Verfahren zum Erkennen eines nicht schaltenden Halbleiterschalters bereitgestellt. Das Verfahren umfasst ein Erfassen eines Verlaufs einer elektrischen Größe eines ersten, mittels eines ersten Ansteuersignals angesteuerten Halbleiterschalters. Das Verfahren umfasst ferner ein Erfassen eines Verlaufs einer elektrischen Größe eines zweiten, mittels eines zweiten Ansteuersignals angesteuerten und zu dem ersten Halbleiterschalter parallel geschalteten Halbleiterschalters. Das Verfahren umfasst ferner ein Ermitteln eines Ausgangssignals basierend auf dem Verlauf der elektrischen Größe des ersten Halbleiterschalters und dem Verlauf der elektrischen Größe des zweiten Halbleiterschalters. Das Ausgangssignal gestattet/ermöglicht das Erkennen eines nicht schaltenden Halbleiterschalters des ersten Halbleiterschalters und/oder des zweiten Halbleiterschalters (eines nicht schaltenden Halbleiterschalters aus dem ersten Halbleiterschalter und/oder dem zweiten Halbleiterschalter). Anders ausgedrückt gestattet/ermöglicht das Ausgangssignal das Erkennen eines Fehlers beim Schalten des ersten Halbleiterschalters und/oder des zweiten Halbleiterschalters. Anders ausgedrückt kann aus dem Ausgangssignal ein Fehler beim Schalten des ersten Halbleiterschalters und/oder des zweiten Halbleiterschalters abgeleitet werden. Der Fehler kann beispielsweise automatisiert oder manuell aus dem Ausgangssignal abgeleitet werden.

Die vorliegende Offenbarung soll weiter anhand von Figuren erläutert werden. Diese Figuren zeigen schematisch:
- Figur 1: ein Gesamtsystem mit Stromversorgung, Leistungsverteiler und elektrischem Verbraucher;
- Figur 2: eine mögliche Ausgestaltung eines Leistungsverteilers aus Figur 1;
- Figur 3: eine mögliche Ausgestaltung eines, in dem Leistungsverteiler aus Figur 2 anwendbaren Schaltsystems gemäß einem Ausführungsbeispiel; und
- Figuren 4a, b: beispielhafte Signalverläufe elektrischer Größen für die Verwendung in dem System aus Figur 3.

Im Folgenden werden, ohne hierauf beschränkt zu sein, spezifische Details dargelegt, um ein vollständiges Verständnis der vorliegenden Offenbarung zu liefern. Es ist einem Fachmann jedoch klar, dass die vorliegende Offenbarung in anderen Ausführungsbeispielen verwendet werden kann, die von den nachfolgend dargelegten Details abweichen können. Beispielsweise werden im Folgenden spezifische Konfigurationen und Ausgestaltungen eines Systems beschrieben, die nicht als einschränkend anzusehen sind.

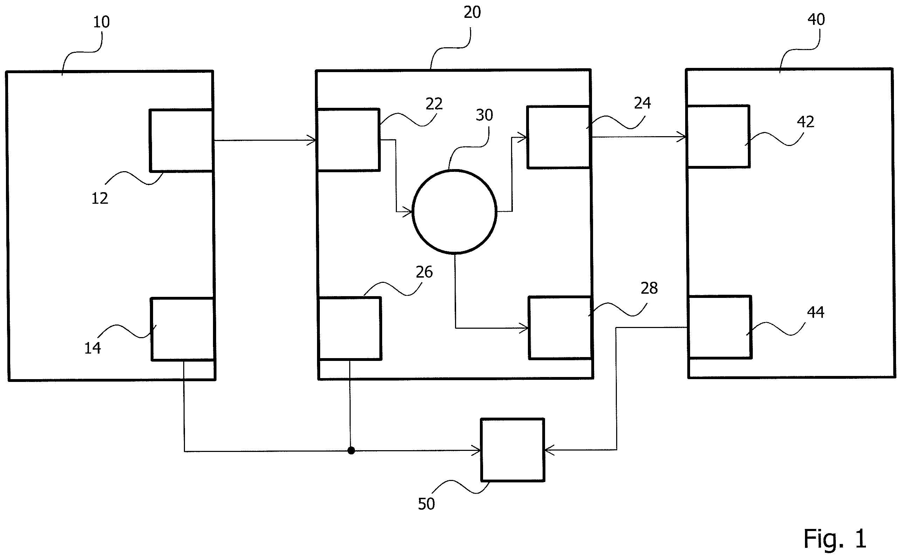

Figur 1 zeigt schematisch ein Leistungsverteilungssystem mit einer Stromversorgung 10, einem Leistungsverteiler 20 und einem elektrischen Verbraucher 40. Die Stromversorgung 10 weist einen positiven Anschluss 12 und einen negativen Anschluss 14 auf. Der Leistungsverteiler 20 weist eingangsseitig einen positiven Anschluss 22 und einen negativen Anschluss 26 auf. Ferner weist der Leistungsverteiler 20 ausgangsseitig einen positiven Anschluss 24 auf. Der Leistungsverteiler 20 weist ein Schaltsystem 30 auf, mit dem der Verbraucher 40 an- und abgeschaltet werden kann. Das Schaltsystem 30 weist eine Steuerung 28 auf. Bei der Steuerung 28 kann es sich um eine übergeordnete Steuerung handeln. Der elektrische Verbraucher 40 weist einen positiven Anschluss 42 und einen negativen Anschluss 44 auf.

Der negative Anschluss 14 der Stromversorgung 10, der negative Anschluss 26 des Leistungsverteilers 20 und der negative Anschluss 44 des Verbrauchers 40 sind jeweils mit Erde/Masse 50 verbunden. Dadurch haben die Stromversorgung 10, der Leistungsverteiler 20 und der Verbraucher 40 das gleiche Bezugspotential, im vorliegenden Fall beispielhaft Masse/Erde 50.

Die Stromversorgung 10 ist über seinen positiven Anschluss 12 mit dem eingangsseitigen positiven Anschluss 22 des Leistungsverteilers 20 verbunden. Der Leistungsverteiler 20 ist ausgangsseitig über seinen ausgangsseitigen positiven Anschluss 24 mit dem elektrischen Verbraucher 40 verbunden. Auch wenn beispielhaft nur ein Verbraucher 40 gezeigt ist, so können mehrere elektrische Verbraucher 40 mit dem Leistungsverteiler 20 verbunden sein, beispielsweise über weitere, in Figur 1 nicht dargestellte ausgangsseitige positive Anschlüsse des Leistungsverteilers 20. Das Schaltsystem 30 ist ausgebildet, den elektrischen Verbraucher 40 an- und abzuschalten. Im Fall mehrerer elektrischer Verbraucher ist das System entsprechend ausgebildet, mehrere elektrische Verbraucher jeweils an- und abzuschalten. Hierfür können ein oder mehrere derartiger Schaltsysteme vorgesehen sein. Ist ein Abschalten nicht möglich, gibt das Schaltsystem 30 eine entsprechende Fehlermeldung an die Steuerung 28. Insbesondere kann es sich bei dem Leistungsverteilungssystem um ein Leistungsverteilungssystem mit hohen Sicherheitsanforderungen (und/oder Zuverlässigkeitsanforderungen) handeln. Bei diesen Systemen ist es umso wichtiger, die Funktionsfähigkeit der verwendeten Schalter (zum An- und Abschalten des Verbrauchers 40) verifizieren zu können.

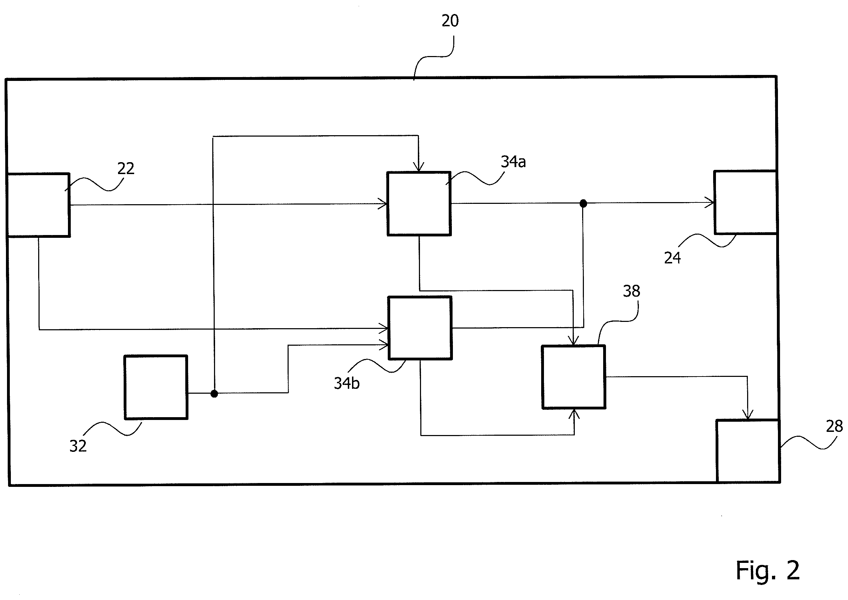

Figur 2 zeigt eine beispielhafte Ausgestaltung eines Leistungsverteilers 20 aus Figur 1. Der Leistungsverteiler 20 weist eingangsseitig einen positiven Anschluss 22 auf. Ferner weist der Leistungsverteiler 20 ausgangsseitig einen positiven Anschluss 24 auf. Ferner weist der Leistungsverteiler eine Steuerung 28 auf. Der negative Anschluss des Leistungsverteilers aus Figur 1 ist der Einfachheit halber in Figur 2 nicht dargestellt. In Figur 2 ist eine beispielhafte Ausgestaltung des Schaltsystems 30 aus Figur 1 gezeigt. Gemäß diesem Beispiel weist das Schaltsystem 30 einen Phasengenerator 32, einen ersten Halbleiterschalter 34a, einen zweiten Halbleiterschalter 34b und einen Komparator 38 auf. Der erste Halbleiterschalter 34a und der zweite Halbleiterschalter 34b dienen dazu, den elektrischen Verbraucher 40 an- und abzuschalten. Insbesondere die Abschaltfunktionalität sollte auf ihre Zuverlässigkeit überwacht werden. Der erste Halbleiterschalter 34a und der zweite Halbleiterschalter 34b sind parallel zueinander geschaltet.

Der Phasengenerator 32 steuert den ersten Halbleiterschalter 34a und den zweiten Halbleiterschalter 34b, z.B. jeweils mit Hilfe eines erzeugten Ansteuersignals, an. Eine erste Erfassungskomponente kann einen Verlauf einer elektrischen Größe des ersten, mittels eines ersten Ansteuersignals angesteuerten Halbleiterschalters 34a erfassen. Eine zweite Erfassungskomponente kann einen Verlauf einer elektrischen Größe des zweiten, mittels eines zweiten Ansteuersignals angesteuerten Halbleiterschalters 34b erfassen. Bei der elektrischen Größe kann es sich beispielsweise um einen elektrischen Strom oder um eine elektrische Spannung handeln. Die erste und/oder die zweite Erfassungskomponente können, wie beispielhaft in Figur 2 vorgesehen, Teil des Komparators 38 sein, d.h. gemäß Figur 2 kann der Komparator 38 die erste und/oder die zweite Erfassungskomponente aufweisen. Alternativ können die erste und/oder die zweite Erfassungskomponente als von dem Komparator 38 getrennte Einrichtungen ausgebildet und angeordnet sein.

Der Komparator 38 kann, als Beispiel für eine Ermittlungseinheit, basierend auf dem Verlauf der elektrischen Größe des ersten Halbleiterschalters 34a und dem Verlauf der elektrischen Größe des zweiten Halbleiterschalters 34b ein Ausgangssignal ermitteln. Das Ausgangssignal kann ein Erkennen eines Fehlers beim Schalten des ersten Halbleiterschalters 34a und/oder des zweiten Halbleiterschalters 34b gestatten/ermöglichen. Anders ausgedrückt können die erfassten Ausgangssignale des ersten Hableiterschalters 34a und des zweiten Halbleiterschalters 34b in dem Komparator 38 miteinander verglichen und ausgewertet werden. Der Komparator 38 erzeugt aus den Ausgangssignalen des ersten und zweiten Halbleiterschalters ein Vergleichssignal als Ausgangssignal. Aus diesem Vergleichssignal lässt sich ableiten, ob der erste Halbleiterschalter 34a und/oder der zweite Halbleiterschalter 34b tatsächlich wie vorgesehen schaltet/schalten oder nicht, insbesondere wie vorgesehen abschaltet/abschalten oder abschaltbar ist/sind. Wird ein Fehler beim Schalten, insbesondere beim Abschalten, festgestellt, wird beispielsweise die Steuerung 28 hierüber informiert. Die Steuerung 28 kann beispielsweise als übergeordnete Instanz entsprechende Maßnahmen treffen, wie z.B. selbst den elektrischen Verbraucher 40 abschalten oder vom Leistungsverteiler 20 trennen oder in einen sicheren Zustand überführen.

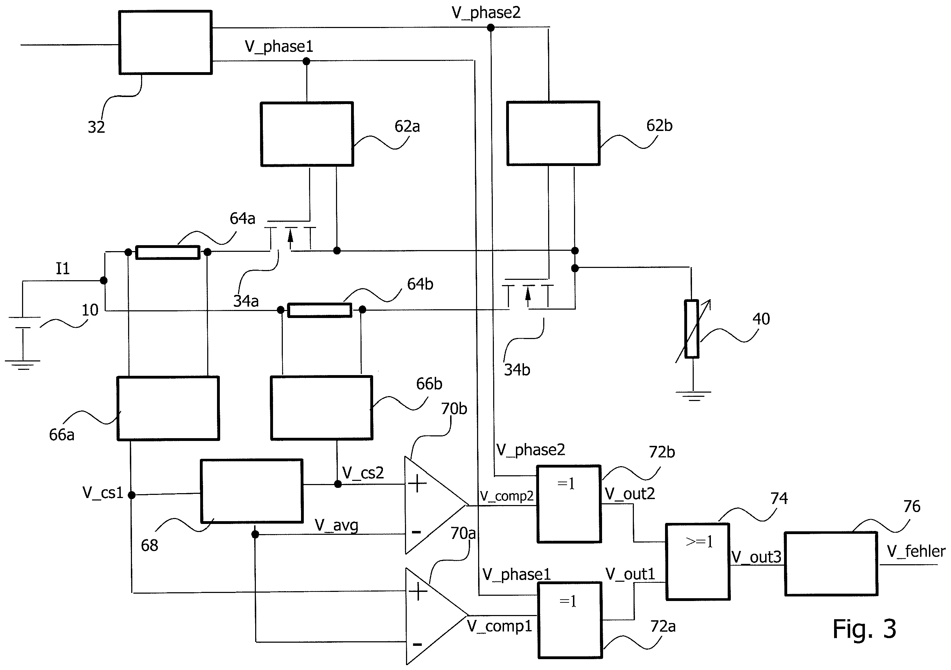

Figur 3 zeigt eine spezifische Ausgestaltung, genauer gesagt eine mögliche Schaltung als Hardware-Realisierung, des Schaltsystems 30. Das Schaltsystem 30 weist einen Phasengenerator 32 auf. Der Phasengenerator 32 ist ausgebildet, ein erstes Ansteuersignal V_phase1 und ein zweites Ansteuersignal V_phase2 zu erzeugen. Das erste Ansteuersignal V_phase1 wird in einen ersten Gate-Treiber 62a eingegeben. Das zweite Ansteuersignal V_phase2 wird in einen zweiten Gate-Treiber 62b eingegeben. Der erste Gate-Treiber 62a ist mit dem Gate-Anschluss des ersten Halbleiterschalters 34a verbunden, der in dem Beispiel aus Figur 3 als erster MOSFET 34a ausgebildet ist und im Folgenden demnach als erster MOSFET 34a bezeichnet wird. Der zweite Gate-Treiber 62b ist mit dem Gate-Anschluss des zweiten Halbleiterschalters 34b verbunden, der in dem Beispiel aus Figur 3 als MOSFET 34b ausgebildet ist und dementsprechend als zweiter MOSFET 34b bezeichnet wird. Der Source-Anschluss des ersten MOSFET 34a ist über einen variablen Widerstand, welcher die Last 40 aus Figur 1 in der Schaltung aus Figur 3 illustriert und dementsprechend ebenfalls mit dem Bezugszeichen 40 bezeichnet wird, mit Masse/Erde verbunden. Der Source-Anschluss des zweiten MOSFET 34b ist über den variablen Widerstand mit Masse/Erde verbunden. Der Drain-Anschluss des ersten MOSFET 34a ist mit einem ersten Strommesswiderstand 64a verbunden. Der erste MOSFET 34a und der erste Strommesswiderstand 64a sind miteinander in Reihe/Serie geschaltet. Der Drain-Anschluss des zweiten MOSFET 34b ist mit einem zweiten Strommesswiderstand 64b verbunden. Der zweite MOSFET 34b und der zweite Strommesswiderstand 64b sind miteinander in Reihe/Serie geschaltet. Über eine geerdete Spannungsquelle 10 wird ein Strom I1 erzeugt. Die Spannungsquelle 10 wird in Figur 3 mit dem Bezugszeichen 10 bezeichnet, da sie der Stromversorgung 10 aus Figur 1 entsprechen kann.

Der erste Messverstärker 66a und der zweite Messverstärker 66b aus Figur 3 können als spezifische Realisierung der ersten Erfassungskomponente bzw. der zweiten Erfassungskomponente (z.B. aus Figur 2) angesehen werden. Der erste Messverstärker 66a ist dazu ausgebildet, eine elektrische Größe an dem ersten Strommesswiderstand 64a zu erfassen. Beispielsweise kann der erste Messverstärker 66a ausgebildet sein, eine an dem ersten Strommesswiderstand 64a anliegende Spannung zu erfassen. Zusätzlich oder alternativ kann der erste Messverstärker 66a ausgebildet sein, einen durch den ersten Strommesswiderstand 64a fließenden elektrischen Strom zu erfassen. Der zweite Messverstärker 66b ist dazu ausgebildet, eine elektrische Größe an dem zweiten Strommesswiderstand 64b zu erfassen. Beispielsweise kann der zweite Messverstärker 66b ausgebildet sein, eine an dem zweiten Strommesswiderstand 64b anliegende Spannung zu erfassen. Zusätzlich oder alternativ kann der zweite Messverstärker 66b ausgebildet sein, einen durch den zweiten Strommesswiderstand 64b fließenden elektrischen Strom zu erfassen.

Der erste und zweite Messverstärker 66a, 66b geben ihre erfassten/gemessenen Werte in einen Mittelwertbildner 68 ein. Ferner wird der von dem ersten Messverstärker 66a gemessene Verlauf der elektrischen Größe in einen positiven (nicht-invertierenden) Eingang eines ersten Komparators 70a eingegeben, der im Folgenden als Operationsverstärkers 70a bezeichnet wird. Ferner wird der von dem zweiten Messverstärker 66b gemessene Verlauf der elektrischen Größe in einen positiven (nicht-invertierenden) Eingang eines zweiten Komparators 70b eingegeben, der im Folgenden als Operationsverstärkers 70b bezeichnet wird. Sowohl der negative (invertierenden) Eingang des ersten Operationsverstärkers 70a als auch der negative (invertierende) Eingang des zweiten Operationsverstärkers 70b werden von dem Mittelwertbildner 68 gespeist.

In dem in Figur 3 gezeigten Beispiel sind die Operationsverstärker 70a, 70b als nichtinvertierende Operationsverstärker ausgebildet (nicht-invertierender Komparator). Bei einem solchen nicht-invertierenden Operationsverstärker wird die Referenzspannung, im Fall aus Figur 3 also der Mittelwert, an den invertierenden Eingang des Operationsverstärkers angeschlossen. Das Eingangssignal, hier der jeweilige Verlauf der elektrischen Größe der Halbleiterschalter 34a, 34b aus den Messverstärkern 66a, 66b, wird jeweils an den nicht-invertierenden Eingang des Operationsverstärkers angeschlossen. Bei einem nicht-invertierenden Operationsverstärker wird als Ausgang eine digitale 0 (ein LOW-Pegel) ausgegeben, wenn die Eingangsspannung kleiner ist als die Referenzspannung. Wenn die Eingangsspannung hingegen gleich groß ist wie oder größer ist als die Referenzspannung, wird eine digitale 1 (ein HIGH-Pegel) ausgegeben. Alternativ wäre es möglich, invertierende Operationsverstärker in Figur 3 vorzusehen.

Der Ausgang des ersten Operationsverstärkers 70a ist mit einem ersten XOR-Gatter 72a verbunden. Dadurch erhält das erste XOR-Gatter 72a als erste Eingangsgröße das Ausgangssignal V_comp1 des ersten Operationsverstärkers 70a. Der Ausgang des zweiten Operationsverstärkers 70b ist mit einem zweiten XOR-Gatter 72b verbunden. Dadurch erhält das zweite XOR-Gatter 72b als erste Eingangsgröße das Ausgangssignal V_comp2 des zweiten Operationsverstärkers 70b. Das erste XOR-Gatter 72a erhält als zweite Eingangsgröße das erste Ansteuersignal V_phase1. Das zweite XOR-Gatter 72b erhält als zweite Eingangsgröße das zweite Ansteuersignal V_phase2. Das erste XOR-Gatter 72a führt demnach eine XOR-Verknüpfung von dem Ausgang des ersten Operationsverstärkers 70a (Signal V_comp1) und dem ersten Ansteuersignal V_phase1 aus. Das zweite XOR-Gatter führt demnach eine XOR-Verknüpfung von dem Ausgang des zweiten Operationsverstärkers 70b (Signal V_comp2) und dem zweiten Ansteuersignal V_phase2 aus.

Die Ausgänge des ersten XOR-Gatters 72a (Signal V_out1) und des zweiten XOR-Gatters 72b (Signal V_out2) werden als Eingangsgrößen in ein OR-Gatter 74 eingegeben. Der Ausgang des OR-Gatters 74 ist daher eine Überlagerung der Ausgänge des ersten und des zweiten XOR-Gatters 72a, 72b.

Aus dem Ausgangssignal des OR-Gatters (Signal V_out3) lassen sich Probleme oder Fehler beim Schalten des ersten MOSFET 34a und/oder des zweiten MOSFET 34b ableiten.

Die Erkennung eines Fehlers lässt sich verbessern, indem hinter das OR-Gatter 74 ein Zeitverzögerungsglied 76 geschaltet wird. Dies kann realisiert werden, indem durch die Zeitverzögerung 76 sogenannte Spikes (als Spikes können kurze Peaks, d.h. Peaks mit einer Dauer unter einem vorgegebenen zeitlichen Schwellenwert, verstanden werden) ausschließt. Das Zeitverzögerungsglied 76 führt dazu, dass nur solche Ungewöhnlichkeiten als Fehler erkannt werden, deren Dauer über einem vorgegebenen zeitlichen Schwellenwert liegt. Das aus dem Zeitverzögerungsglied 76 ausgegebene Signal kann folglich als Fehlersignal V_fehler bezeichnet werden. Anders ausgedrückt kann das Zeitverzögerungsglied 76 als Einschaltverzögerung bezeichnet werden, die dazu führt, dass nur Fehlersignale über einer bestimmten Länge als gültig, d.h. als tatsächliche/gültige Fehlersignale, bewertet werden.

Unter Bezugnahme auf Figur 3 kann der Komparator aus Figur 2 beispielsweise implementiert sein durch die Messverstärker 66a, 66b, den Mittelwertbildner 68, die Operationsverstärker 70a, 70b, die XOR-Gatter 72a, 72b und das OR-Gatter 74 aus Figur 3. Alternative Realisierungen sind möglich, bei denen eine oder mehrere der vorgenannten Komponenten entfallen, ersetzt werden und/oder weitere Komponenten hinzukommen. Die Figur 3 ist somit lediglich als beispielhafte Hardware-Realisierung des Schaltsystems aus Figur 2 anzusehen.

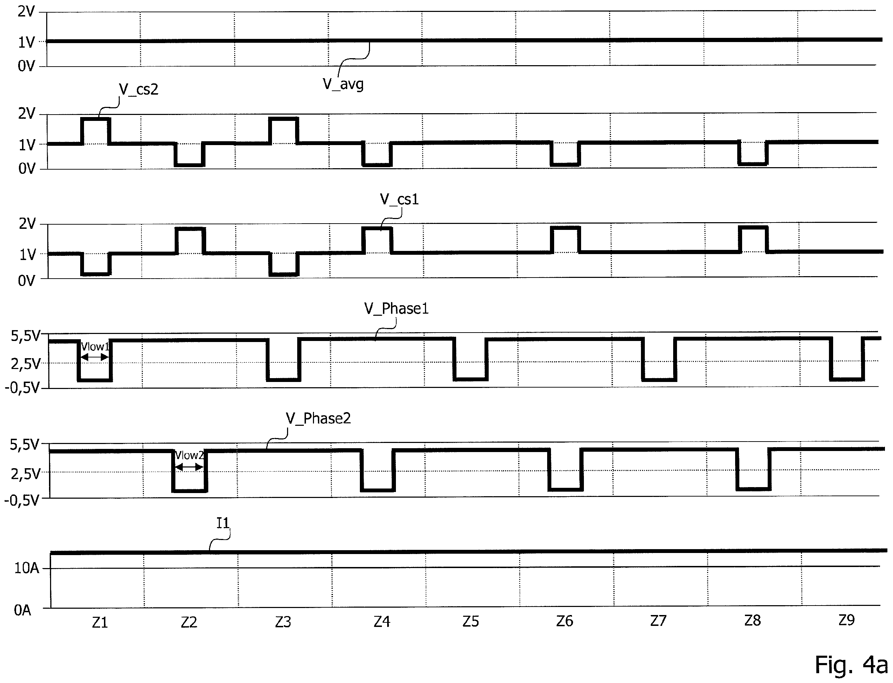

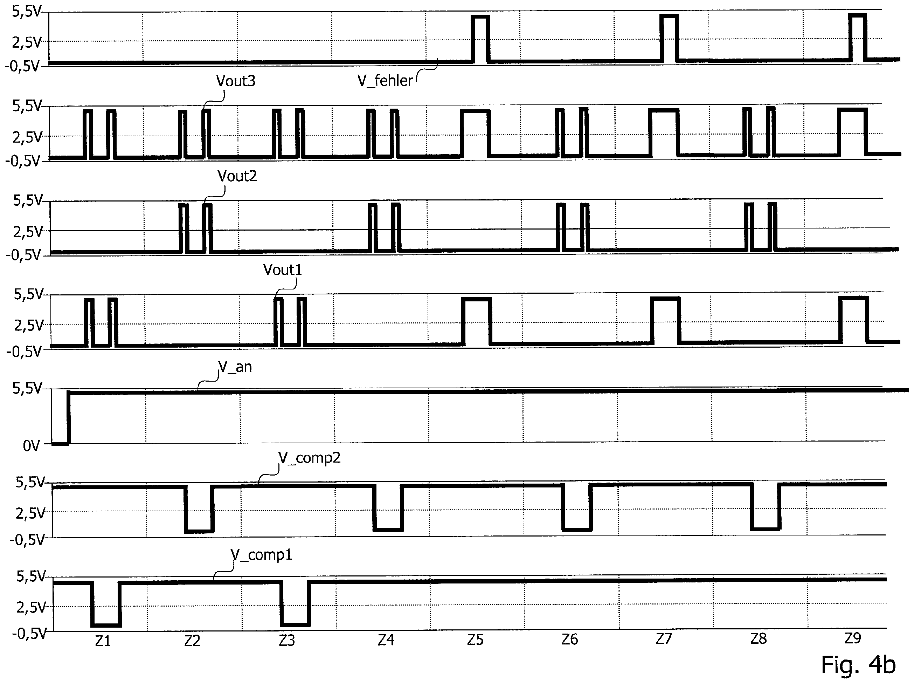

Die Funktionsweise der Ausgestaltung aus Figur 3 wird nun anhand von beispielhaften Signalverläufen aus Figuren 4a und 4b genauer beschrieben. In den Figuren 4a und 4b sind die Signalverläufe jeweils über der Zeit gezeigt. Dabei zeigt jeweils die Ordinate die jeweilige elektrische Größe, z.B. Strom oder Spannung, und die Abszisse die Zeit. Die Abszisse ist in mehrere Bereiche (genauer gesagt, neun Bereiche) unterteilt, die jeweils hierin als Zeitfenster Z1 bis Z9 bezeichnet werden.

Beide MOSFETS 34a, 34b sind in dem Beispiel als selbstsperrende n-Kanal-MOSFETS ausgebildet. Daher sind die MOSFETS 34a, 34b in einem geschlossenen Zustand und leiten Strom, wenn die die Spannung zwischen Gate und Source einen Schwellwert überschreitet. Der Schwellwert liegt jeweils unter den beispielhaft in Figur 4a und 4b als Maximalerwerte der Ansteuersignale V_phase1, V_phase2 angenommenen 5V.

Wie in Bezug auf die beispielhaften Signalverläufe in den Figuren 4a und 4b zu erkennen, beginnen beide Ansteuersignale V_phase1, V_phase2 im ersten Zeitfenster Z1 mit einem Wert von ungefähr 5V. Dies entspricht einem hohen Pegel, auch als HIGH bezeichnet (digitale 1). Aufgrund der HIGH-Pegel der Ansteuersignale V_phase1, V_phase2 liegt eine Spannung zwischen Gate und Source des ersten MOSFET 34a und zwischen Gate und Source des zweiten MOSFET 34b an, die den Schwellwert der MOSFETS 34a, 34b übersteigt. Beide MOSFETS 34a, 34b befinden sich daher in einem geschlossenen Zustand.

In der beispielhaften Ausgestaltung aus Figur 3 entspricht der Gesamtwiderstand aus dem ersten Strommesswiderstand 64a und dem ersten MOSFET 34a zumindest nahezu genau dem Gesamtwiderstand aus dem zweiten Strommesswiderstand 64b und dem zweiten MOSFET 34b. Sind beide MOSFETS 34a, 34b geschlossen, teilt sich der Strom I1 daher zumindest nahezu gleich auf die Parallelschaltung der beiden MOSFETS 34a, 34b auf. Daher fließt durch beide Zweige der Schaltung zumindest nahezu 11/2. Ein erster Messverstärker 66a kann beispielsweise direkt den Strom durch den ersten Strommesswiderstand 64a messen. Ein zweiter Messverstärker 66b kann beispielsweise direkt den Strom durch den zweiten Strommesswiderstand 64b messen. Alternativ kann der erste Messverstärker 66a die über dem ersten Strommesswiderstand 64a abfallende Spannung messen. Ferner kann der zweite Messverstärker 66b die über dem zweiten Strommesswiderstand 64b abfallende Spannung messen. Unabhängig von der Messmethode ermitteln der erste Messverstärker 66a und der zweite Messverstärker 66b eine zumindest nahezu gleich große elektrische Größe, wenn sowohl der erste MOSFET 34a als auch der zweite MOSFET 34b geschlossen sind.

Nach einer Zeit wird das erste Ansteuersignal V_phase1 in dem ersten Zeitfenster Z1 für eine Zeitspanne Vlow1 auf eine Spannung von ungefähr 0V gesetzt. Dies entspricht einem tiefen Pegel, auch als LOW-Pegel (digitale 0) bezeichnet. In diesem Fall liegt zwischen Gate und Source des ersten MOSFET 34a, wenn überhaupt, nur noch eine sehr geringe Spannung an, die unter dem Schwellwert des ersten MOSFET 34a liegt. Der MOSFET 34a geht daher in einen offenen Zustand über. Während der gleichen Zeitspanne Vlow1 des ersten Zeitfensters Z1 befindet sich das zweite Ansteuersignal V_phase2 weiter auf einem HIGH-Pegel. Der zweite MOSFET 34b ist daher weiter geschlossen. Da der erste MOSFET 34a in der ersten Zeitspanne Vlow1 des ersten Zeitfensters Z1 offen ist und der zweite MOSFET 34b in der ersten Zeitspanne Vlow1 des ersten Zeitfensters Z1 geschlossen ist, fließt der Strom I1 zumindest nahezu vollständig über den Zweig der Parallelschaltung der beiden MOSFETs, in dem sich der zweite MOSFET 34b befindet. Der erste Messverstärker 64a ermittelt daher einen Wert von zumindest nahezu 0 als elektrische Größe. Der zweite Messverstärker 64b ermittelt zur gleichen Zeit einen Wert, der zumindest nahezu dem Strom I1 entspricht oder der Multiplikation aus Strom I1 und Strommesswiderstand 64b. Dies entspricht dem Doppelten des Mittelwerts. Der erste Messverstärker 64a ermittelt in der gleichen Zeitspanne Vlow1 einen Wert von zumindest nahezu 0 als elektrische Größe.

Das zweite Ansteuersignal wird in einem zweiten Zeitfenster Z2 für eine Zeitspanne Vlow2 auf einen tiefen Pegel, LOW-Pegel (digitale 0) geschaltet. In diesem Fall liegt zwischen Gate und Source des zweiten MOSFET 34b, wenn überhaupt, nur noch eine sehr geringe Spannung an, die unter dem Schwellwert des zweiten MOSFET 34b liegt. Der MOSFET 34b geht daher in einen offenen Zustand über. Während der gleichen Zeitspanne Vlow2 des zweiten Zeitfensters Z2 befindet sich das erste Ansteuersignal V_phase1 bei einem HIGH-Pegel. Der erste MOSFET 34a ist daher geschlossen. Da der erste MOSFET 34a in der Zeitspanne Vlow2 des zweiten Zeitfensters Z2 geschlossen ist und der zweite MOSFET 34b in der Zeitspanne Vlow2 des zweiten Zeitfensters Z2 offen ist, fließt der Strom I1 zumindest nahezu vollständig über den Zweig der Parallelschaltung der beiden MOSFETs, in dem sich der erste MOSFET 34a befindet. Der erste Messverstärker 64a ermittelt daher einen Wert als elektrische Größe, der zumindest nahezu dem Strom I1 entspricht oder der Multiplikation aus Strom 11 und Strommesswiderstand 64a. Dies entspricht dem Doppelten des Mittelwerts. Der zweite Messverstärker 64b ermittelt in der gleichen Zeitspanne Vlow2 einen Wert von zumindest nahezu 0 als elektrische Größe.

Befinden sich der erste MOSFET 34a und der zweite MOSFET 34b jeweils in einem geschlossenen Zustand ermitteln die beiden Messverstärker 66a, 66b, wie beschrieben, einen zumindest nahezu gleich großen Wert für die gemessene elektrische Grö-ße. Der Mittelwertbildner 68 bildet aus den gemessenen Größen den Mittelwert. Im Fall gleich großer Werte entspricht der Mittelwert der elektrischen Größe zumindest nahezu dem gemessenen Wert selbst. Daher stellt der Operationsverstärker 70a keinen Unterschied zwischen der von dem ersten Messverstärker 66a gemessenen Größe V_cs1 und dem Mittelwert V_avg aus dem Mittelwertbildner 68 fest und gibt dementsprechend einen HIGH-Pegel (eine 1) aus. Ferner stellt der Operationsverstärker 70b keinen Unterschied zwischen der von dem zweiten Messverstärker 66b gemessenen Größe V_cs2 und dem Mittelwert V_avg aus dem Mittelwertbildner 68 fest und gibt dementsprechend einen HIGH-Pegel (eine 1) aus.

Befindet sich der erste MOSFET 34a in einem offenen Zustand und der zweite MOSFET 34b in einem geschlossenen Zustand (siehe z.B. die Zeitspanne Vlow1 in dem ersten Zeitfenster Z1 und dem dritten Zeitfenster Z3) ermittelt der erste Messverstärker 66a einen Minimalwert von 0 und der zweite Messverstärker 66b den Maximalwert. Der Mittelwertbildner 68 bildet aus den gemessenen Größen den Mittelwert. Daher stellt der erste Operationsverstärker 70a fest, dass der Wert der elektrischen Ausgangsgröße V_cs1 des ersten Messverstärkers 66a unter dem Mittelwert liegt und gibt dementsprechend einen LOW-Pegel (digitale 0) aus. Ferner stellt der Operationsverstärker 70b fest, dass der Wert der elektrischen Ausgangsgröße V_cs2 des zweiten Messverstärkers 66b nicht unter dem Mittelwert aus dem Mittelwertbildner 68 liegt und gibt dementsprechend einen HIGH-Pegel (eine 1) aus (siehe Signal V_comp1).

Befindet sich der erste MOSFET 34a in einem geschlossenen Zustand und der zweite MOSFET 34b in einem offenen Zustand (siehe z.B. die Zeitspanne Vlow2 in dem zweiten Zeitfenster Z2 und dem vierten Zeitfenster Z4) ermittelt der erste Messverstärker 66a einen Maximalwert und der zweite Messverstärker 66b einen Minimalwert von 0. Der Mittelwertbildner 68 bildet aus den gemessenen Größen den Mittelwert. Daher stellt der Operationsverstärker 70a fest, dass der Wert der elektrischen Ausgangsgröße V_cs1 des ersten Messverstärkers 66a nicht unter dem Mittelwert liegt und gibt dementsprechend einen HIGH-Pegel (digitale 1) aus. Ferner stellt der Operationsverstärker 70b fest, dass der Wert der elektrischen Ausgangsgröße V_cs2 des zweiten Messverstärkers 66b unter dem Mittelwert aus dem Mittelwertbildner 68 liegt und gibt dementsprechend einen LOW-Pegel (digitale 0) aus (siehe Signal V_comp2).

Bei offenem ersten MOSFET 34a ergibt sich daher auf ungefährer zeitlicher Höhe des LOW-Pegels des ersten Ansteuersignals V_phase1, d.h. ungefähr auf Höhe der Zeitspanne Vlow1 im ersten Zeitfenster Z1 und im dritten Zeitfenster Z3, ein durch Laufzeitverzögerungen und/oder Schaltverzögerungen entstandener Doppelpeak als Ausgangsgröße V_out1 des ersten XOR-Gatters 72a. Bei offenem zweiten MOSFET 34b ergibt sich daher auf ungefährer zeitlicher Höhe des LOW-Pegels des zweiten Ansteuersignals V_phase2, d.h. ungefähr auf Höhe der Zeitspanne Vlow2 im zweiten Zeitfenster Z2 und im vierten Zeitfenster Z4 (und ebenso im sechsten Zeitenfenster Z6 und achten Zeitfenster Z8), ein Doppelpeak als Ausgangsgröße V_out2 des zweiten XOR-Gatters 72b. Die Ausgänge des ersten XOR-Gatters 72a und des zweiten XOR-Gatters 72b werden als Eingangsgrößen in ein OR-Gatter 74 gegeben. Der Ausgang des OR-Gatters 74 ist daher eine Überlagerung der Ausgänge des ersten 72a und des zweiten XOR-Gatters 72b. Das Ausgangssignal V_out3 des OR-Gatters 74 zeigt daher im ersten Zeitfenster Z1 bis vierten Zeitfenster Z4 (und ebenso im sechsten Zeitenfenster Z6 und achten Zeitfenster Z8) einen Doppelpeak, der jeweils das Öffnen des ersten bzw. zweiten MOSFETS 34a, 34b anzeigt.

Wird nun beispielhaft angenommen, dass in dem fünften Zeitfenster Z5, siebten Zeitfenster Z7 und neunten Zeitfenster Z9 der erste MOSFET 34a nicht korrekt öffnet, obwohl das erste Ansteuersignal V_phase1 in der Zeitspanne Vlow1 einen LOW-Pegel annimmt, bleibt der MOSFET 34a in dem fünften Zeitfenster Z5, siebten Zeitfenster Z7 und neunten Zeitfenster Z9 in dem geschlossenen Zustand. Wie erläutert, teilt sich der Strom I1 in diesem Fall zumindest nahezu gleich auf die Parallelschaltung der MOSFETS 34a, 34b auf. Jeder der MOSFETs 34a, 34b und damit jeder Strommesswiderstand 64a, 64b wird daher von einem Strom mit einem Wert von zumindest nahezu I1/2 durchflossen. Die Messverstärker 66a, 66b ermitteln daher einen zumindest nahezu gleich großen Wert. Beide Operationsverstärker 70a, 70b stellen daher keinen Unterschied zwischen den Messwerten der Messverstärker 66a, 66b und dem Mittelwert fest. Beide Operationsverstärker 70a, 70b geben daher im fünften Zeitfenster Z5, siebten Zeitfenster Z7 und neunten Zeitfenster Z9 für die Signale V_comp1, V_comp2 auch während der Zeitspanne Vlow1 einen HIGH-Pegel aus. Die XOR-Verknüpfung des Ausgangs des ersten Operationsverstärker 72a mit dem ersten Ansteuersignal V_phase1 führt daher zu einem (einzigen) HIGH-Pegel ungefähr während der Zeitspanne Vlow1 des fünften Zeitfensters Z5 (V_out1), nicht zu einem Doppelpeak. Die XOR-Verknüpfung des Ausgangs des zweiten Operationsverstärker 72b mit dem zweiten Ansteuersignal V_phase2 führt zu einem LOW-Pegel (V_out2). Die OR-Verknüpfung der Ausgänge beider XOR-Gatter 72a, 72b führt im fünften Zeitfenster Z5, siebten Zeitfenster Z7 und neunten Zeitfenster Z9 daher jeweils zu einem (einzigen) Peak (zumindest ungefähr auf Höhe der Zeitspanne Vlow1 im fünften Zeitfenster Z5, siebten Zeitfenster Z7 und neunten Zeitfenster Z9). Dieser eine Peak (statt einem durch Laufzeitverzögerungen und/oder Schaltverzögerungen entstandenen Doppelpeak mit jeweils kleinerer Breite jedes Peaks) in dem Ausgangssignal des OR-Gatters 74 (V_out3) zeigt daher einen Fehler an.

Die Erkennung eines Fehlers lässt sich verbessern, indem hinter das OR-Gatter 74 eine Zeitverzögerung geschaltet wird, die im Folgenden teilweise als Zeitverzögerungsglied 76 bezeichnet wird. Die Zeitverzögerung führt dazu, dass nur solche Peaks als Fehler erkannt werden, deren Dauer über einem vorgegebenen zeitlichen Schwellenwert liegt. Die Dauer der Doppelpeaks im ersten Z1 bis vierten Zeitfenster Z4 (und ebenso im sechsten Zeitfenster Z6 und achten Zeitfenster Z8) liegt jeweils unter dem zeitlichen Schwellenwert. Daher gibt der Ausgang des Zeitverzögerungsglieds 76 einen LOW-Pegel aus (siehe Signal V_fehler). Die Dauer der Peaks im fünften Zeitfenster Z5, siebten Zeitfenster Z7 und neunten Zeitfenster Z9 liegen hingegen über dem zeitlichen Schwellenwert. Das Zeitverzögerungsglied 76 gibt daher im fünften Zeitfenster Z5, siebten Zeitfenster Z7 und neunten Zeitfenster Z9 für eine bestimmte Dauer einen HIGH-Pegel aus (siehe Signal V_fehler).

Gemäß einer spezifischen Realisierung der Zeitverzögerung kann das Zeitverzögerungsglied 76 als Einschaltverzögerung ausgebildet sein oder eine Einschaltverzögerung bewirken. In diesem Fall kann das Zeitverzögerungsglied 76 beispielsweise ein zeitlich verzögertes Einschalten bewirken oder zeitlich verzögert einschalten. Die zeitliche Verzögerung kann mindestens dem Betrag (in zeitlicher Sicht) eines der Pulse der Doppelpulse der Signale Vout1, Vout2, Vout3 entsprechend oder über diesen liegen. Dadurch werden die jeweiligen Pulse dieser Doppelpulse unterdrückt oder ausgeblendet und nur die längeren Pulse (d.h. die Pulse mit einer Breite größer als die zeitliche Verzögerung bzw. größer als die Breite jedes Peaks der Doppelpeaks) werden, jeweils verkürzt durch den Betrag der zeitlichen Verzögerung im Fehlersignal V_fehler ausgegeben. Dies ist in Fig. 4b zu erkennen, in der ein gültiges Fehlersignal V_fehler gezeigt ist. Bei dem Signal V_fehler ist jeweils die steigende Flanke eines Fehlerpulses um den Betrag der Einschaltverzögerung zur steigenden Flanke eines langen Peaks beispielsweise im Signal Vout3 versetzt oder verkürzt (d.h. mindestens um die Breite eines Pulses eines Doppelpulses/Doppelpeaks verkürzt). Die fallende Flanke des Pulses des Fehlersignals V_fehler fällt hingegen zur selben Zeit ab wie der entsprechende Puls bei dem Signal Vout3, da es sich lediglich um eine Einschaltverzögerung handelt und nicht um eine Ausschaltverzögerung. Dies betrifft alle Zeitslots mit Fehlern, d.h. Z5, Z7 und Z9. Die Pulse jedes Doppelpulses werden dagegen durch die Einschaltverzögerung unterdrückt. Bei diesen handelt es sich schließlich nicht um tatsächliche/gültige Fehlerpulse.

Im Ergebnis zeigt das Ausgangssignal V_fehler des Zeitverzögerungsglieds 76 nur dann einen Peak, wenn ein Fehler beim Schalten eines der MOSFETS 64a, 64b vorliegt. Laufzeitverzögerungen werden hingegen unterdrückt. Der Ausgang der Zeitverzögerung 76 kann daher als Fehlersignal V_fehler bezeichnet werden. Mittels einer Erkennungsschaltung können die Peaks im Fehlersignal V_fehler automatisch erkannt werden. Anhand der Peaks und der Ansteuersignale kann die Erkennungsschaltung unmittelbar darauf schließen, welcher der beiden MOSFETS 34a, 34b nicht korrekt geschaltet hat. Der Fehler kann daher nicht nur zeitnah erkannt werden sondern es kann zeitnah ein Austausch des betroffenen Bauteils oder eine andere Reaktion zur Behebung des Fehlers erfolgen.

Die Figuren 3, 4a und 4b können wie folgt zusammengefasst werden. In der in Figur 3 gezeigten Schaltung werden zwei Leistungshalbleiter (MOSFET) 34a, 34b zusammen mit jeweils einem Strommesswiderstand (Shunt) 64a, 64b zueinander parallel geschaltet. Durch eine Logik werden beide Leistungshalbleiter 34a, 34b abwechselnd aus- und eingeschaltet. Dabei ist im Idealzustand (fehlerfreien Zustand) immer mindestens ein Leistungshalbleiter 34a, 34b eingeschaltet. Über die beiden Shunts 64a, 64b wird jeweils über einen eigenen Strommessverstärker 66a, 66b der Strom durch jeden der beiden parallelen Pfade gemessen. Wenn beide MOSFETs 34a, 34b an sind (geschlossen), wird über beide Messverstärker 66a, 66b der annähernd gleiche Strom gemessen (jeweils der halbe Laststrom I1). Sobald einer der beiden MOSFETs 34a, 34b abschaltet, fließt über einen der beiden Pfade der volle Laststrom I1 während der andere Pfad keinen Strom mehr führt. Der Mittelwert der beiden Ströme bleibt aber weiterhin gleich. Durch zwei Komparatoren (Vergleicher/Operationsverstärker) 70a, 70b wird das Ausgangssignal V_cs1, V_cs2 der beiden Strommessverstärker 66a, 66b mit dem Mittelwert verglichen und durch die Komparatoren 70a, 70b in digitale Signale umgewandelt. Die Signalform der Komparatoren 70a, 70b entspricht damit in groben Zügen der Signalfolge V_phase1, V_phase2, mit der der jeweilige MOSFET 34a, 34b angesteuert wird. Durch Vergleichen des jeweiligen Ansteuersignals V_phase1, V_phase2 der MOSFETs 34a, 34b mit dem Ausgangssignal V_comp1, V_comp2 des jeweiligen Komparators 70a, 70b mittels Exklusiv-ODER Verknüpfung (XOR-Verknüpfung) kann nun detektiert werden, ob der jeweilige MOSFET 34a, 34b tatsächlich abschaltet. Die beiden XOR-verknüpften Signale V_out1, V_out2 der beiden MOSFETs 34a, 34b werden anschließend durch eine ODER-Verknüpfung zu einem Signal V_out3 kombiniert und durch eine Einschaltverzögerung 76 gefiltert. Die Einschaltverzögerung 76 ist vorteilhaft, um durch Signallaufzeiten und/oder Schaltverzögerungen ausgelöste fehlerhafte Diagnosen zu unterbinden. Als Ausgangssignal V_fehler erhält man eine Pulsfolge, die ungefähr (wenn auch verkürzt) den Ansteuerpulsen des defekten MOSFET 34a, 34b entspricht. Das Ausgangssignal V_fehler der Einschaltverzögerung 76 kann nun durch eine übergeordnete Steuerung eingelesen und verarbeitet werden (nicht dargestellt, aber siehe Steuerung 28 in Figur 2). Alternativ kann durch ein Speicherglied die Pulsfolge in einen statischen Wert gewandelt werden (nicht dargestellt).

Auch wenn in der Beschreibung der Ausführungsbeispiele aus den Figuren 2 bis 4b darauf Bezug genommen wurde, zu erkennen, ob der erste 34a und/oder zweite Halbleiterschalter 34b korrekt von einem geschlossenen in einen offenen Zustand überführt wird, so kann entsprechend aus den Signalverläufen erkannt werden, ob der erste 34a und/oder zweite Halbleiterschalter 34b korrekt von einem offenen in einen geschlossenen Zustand überführt wird.

Die Erkennung eines nicht schaltendenden Halbleiterschalters des ersten und/oder zweiten Halbleiterschalters 34a, 34b ermöglicht die Verwendung einfacher und kostengünstiger Bauteile und es kann auf eine Reihenschaltung jeweils eines weiteren Halbleiterschalters zu Redundanzzwecken verzichtet werden.

Auch wenn in der Beschreibung der Ausführungsbeispiele aus den Figuren 2 bis 4b stets nur auf einen ersten 34a und einen zweiten Halbleiterschalter 34b Bezug genommen wird, so sind diese Ausführungsbeispiele und die Erfindung im Allgemeinen nicht auf exakt zwei parallel geschaltete Halbleiterschalter beschränkt. Ebenso können drei oder mehr als drei Halbleiterschalter vorgesehen sein. Zusammengefasst können daher mindestens zwei Halbleiterschalter vorhanden sein und es kann mindestens ein nicht schaltender Halbleiterschalter aus diesen mindestens zwei parallel geschalteten Halbleiterschaltern erkannt werden.

Ein Vorteil der Parallelschaltung mindestens eines dritten Halbleiterschalters zu dem ersten 34a und zweiten Halbleiterschalter 34b wird nun in Bezug auf die Figuren 3 bis 4b beschrieben, ohne den mindestens einen dritten Halbleiterschalter in den Figuren darzustellen.

Wie beschrieben, wird im ersten Zeitfenster Z1 der erste Halbleiterschalter 34a geöffnet, wenn das erste Ansteuersignal V_phase1 in der Zeitspanne Vlow1 einen LOW-Pegel annimmt. Nach Ablauf der Zeitspanne Vlow1 nimmt das erste Ansteuersignal V_phase1 wieder einen HIGH-Pegel an. Der erste Halbleiterschalter 34a würde in diesem Fall wieder schließen. Ist der erste Halbleiterschalter 34a jedoch defekt, bleibt der erste Halbleiterschalter 34a offen, d.h. er geht nicht mehr zu, obwohl das erste Ansteuersignal V_phase1 wieder einen HIGH-Pegel angenommen hat. Wie beschrieben, wird im zweiten Zeitfenster Z2 während der Zeitspanne Vlow2 der zweite Halbleiterschalter 34b öffnen, da das zweite Ansteuersignal während der Zeitspanne Vlow2 einen LOW-Pegel annimmt. Folglich sind während der Zeitspanne Vlow2 sowohl der erste Halbleiterschalter 34a offen (da er nicht mehr schließt, obwohl er eigentlich geschlossen sein sollte) als auch der zweite Halbleiterschalter 34b offen (aufgrund des LOW-Pegels des zweiten Ansteuersignals V_phase2). Somit schaltet die Last während der Zeitspanne Vlow2 (kurz) in den Zeitfenstern Z2, Z4, Z6, Z8 ab.

Ist hingegen noch mindestens ein dritter Halbleiterschalter parallel geschaltet, kann dieser - bei korrekter Schaltung - eine Art Notlaufbetrieb ermöglichen. Denn der mindestens eine dritte Halbleiterschalter wird während der Zeitspanne Vlow2 mit Hilfe mindestens eines dritten Ansteuersignals, welches während der Zeitspanne Vlow2 einen HIGH-Pegel annimmt, sich in einem geschlossenen Zustand befinden. Demzufolge ist die Last nicht vom System und der Stromversorgung getrennt und wird folglich nicht abgeschaltet.

## Patentansprüche

1. System zum Erkennen eines nicht schaltenden Halbleiterschalters, wobei das System aufweist:
eine erste Erfassungskomponente, die ausgebildet ist, einen Verlauf einer elektrischen Größe eines ersten, mittels eines ersten Ansteuersignals angesteuerten Halbleiterschalters (34a) zu erfassen;
eine zweite Erfassungskomponente, die ausgebildet ist, einen Verlauf einer elektrischen Größe eines zweiten, mittels eines zweiten Ansteuersignals angesteuerten und zu dem ersten Halbleiterschalter (34a) parallel geschalteten Halbleiterschalters (34b) zu erfassen;
eine Ermittlungseinheit, die ausgebildet ist, basierend auf dem Verlauf der elektrischen Größe des ersten Halbleiterschalters (34a) und dem Verlauf der elektrischen Größe des zweiten Halbleiterschalters (34b) ein Ausgangssignal zu ermitteln, das ein Erkennen eines nicht schaltenden Halbleiterschalters des ersten Halbleiterschalters (34a) und/oder des zweiten Halbleiterschalters (34b) gestattet, **dadurch gekennzeichnet, dass** die Ermittlungseinheit aufweist:
eine erste Vergleichskomponente, die ausgebildet ist, einen ersten Vergleichsverlauf zu ermitteln durch Vergleichen des Verlaufs der elektrischen Größe des ersten Halbleiterschalters (34a) mit einem Verlauf eines Mittelwerts aus dem Verlauf der elektrischen Größe des ersten Halbleiterschalters (34a) und dem Verlauf der elektrischen Größe des zweiten Halbleiterschalters (34b); und
eine zweite Vergleichskomponente, die ausgebildet ist, einen zweiten Vergleichsverlauf zu ermitteln durch Vergleichen des Verlaufs der elektrischen Größe des zweiten Halbleiterschalters (34b) mit dem Verlauf des Mittelwerts aus dem Verlauf der elektrischen Größe des ersten Halbleiterschalters (34a) und dem Verlauf der elektrischen Größe des zweiten Halbleiterschalters (34b).

2. System nach Anspruch 1, wobei
die erste Erfassungskomponente einen ersten Messverstärker (66a) aufweist oder als erster Messverstärker (66a) ausgebildet ist, wobei der erste Messverstärker (66a) beispielsweise ausgebildet ist, als Verlauf der elektrischen Größe des ersten Halbleiterschalters (34a) einen Verlauf eines elektrischen Stroms durch einen zu dem ersten Halbleiterschalter (34a) in Reihe geschalteten ersten Strommesswiderstand (64a) zu ermitteln; und/oder
die zweite Erfassungskomponente einen zweiten Messverstärker (66b) aufweist oder als zweiter Messverstärker (66b) ausgebildet ist, wobei der zweite Messverstärker (66b) beispielsweise ausgebildet ist, als Verlauf der elektrischen Größe des zweiten Halbleiterschalters (34b) einen Verlauf eines elektrischen Stroms durch einen zu dem zweiten Halbleiterschalter (34b) in Reihe geschalteten zweiten Strommesswiderstand (64b) zu ermitteln.

3. System nach Anspruch 1 oder 2, wobei das von der Ermittlungseinheit ermittelte Ausgangssignal ein Erkennen eines Fehlers beim Schalten des ersten Halbleiterschalters (34a) und/oder des zweiten Halbleiterschalters (34b) von einem geschlossenen in einen offenen Schaltzustand gestattet.

4. System nach einem der Ansprüche 1 bis 3, wobei das System ferner eine Erkennungskomponente aufweist, die ausgebildet ist, den Fehler beim Schalten des ersten Halbleiterschalters (34a) und/oder des zweiten Halbleiterschalters (34b) basierend auf dem Ausgangssignal zu erkennen.

5. System nach einem der Ansprüche 1 bis 4, wobei das System ferner ein Verzögerungsglied aufweist, das ausgebildet ist, ein Fehlersignal durch Kombination des Ausgangssignals mit einer Einschaltverzögerung zu ermitteln.

6. System nach einem der Ansprüche 1 bis 5, wobei
die erste Vergleichskomponente einen Komparator (70a) aufweist oder als Komparator (70a) ausgebildet ist; und/oder
die zweite Vergleichskomponente einen Komparator (70b) aufweist oder als Komparator (70b) ausgebildet ist.

7. System nach einem der Ansprüche 1 bis 6, wobei die Ermittlungseinheit aufweist:
eine erste Verknüpfungskomponente, die ausgebildet ist, ein erstes Verknüpfungssignal durch Verknüpfen des ersten Vergleichsverlaufs mit dem ersten Ansteuersignal zu ermitteln;
eine zweite Verknüpfungskomponente, die ausgebildet ist, ein zweites Verknüpfungssignal durch Verknüpfen des zweiten Vergleichsverlaufs mit dem zweiten Ansteuersignal zu ermitteln;
eine dritte Verknüpfungskomponente, die ausgebildet ist, das Ausgangssignal durch Verknüpfen des ersten Verknüpfungssignals mit dem zweiten Verknüpfungssignal zu ermitteln.

8. System nach Anspruch 7, wobei
die erste Verknüpfungskomponente als XOR-Gatter (72a) ausgebildet ist; und/oder die zweite Verknüpfungskomponente als XOR-Gatter (72b) ausgebildet ist; und/oder die dritte Verknüpfungskomponente als ODER-Gatter (74) ausgebildet ist.

9. System nach einem der Ansprüche 1 bis 8, wobei der erste Halbleiterschalter (34a) und/oder der zweite Halbleiterschalter (34b) als Leistungshalbleiter ausgebildet ist/sind; und/oder wobei das System aufweist:
den ersten Halbleiterschalter (34a); und/oder
den zweiten, zu dem ersten Halbleiterschalter (34a) parallel geschalteten Halbleiterschalter (34b); und/oder
mindestens einen dritten, zu dem ersten und zweiten Halbleiterschalter parallel geschalteten Halbleiterschalter.

10. Verfahren zum Erkennen eines nicht schaltenden Halbleiterschalters, wobei das Verfahren umfasst:
Erfassen eines Verlaufs einer elektrischen Größe eines ersten, mittels eines ersten Ansteuersignals angesteuerten Halbleiterschalters (34a);
Erfassen eines Verlaufs einer elektrischen Größe eines zweiten, mittels eines zweiten Ansteuersignals angesteuerten und zu dem ersten Halbleiterschalter (34a) parallel geschalteten Halbleiterschalters (34b);
Ermitteln eines Ausgangssignals basierend auf dem Verlauf der elektrischen Größe des ersten Halbleiterschalters (34a) und dem Verlauf der elektrischen Größe des zweiten Halbleiterschalters (34b), wobei das Ausgangssignal das Erkennen eines nicht schaltenden Halbleiterschalters des ersten Halbleiterschalters (34a) und/oder des zweiten Halbleiterschalters (34b) gestattet, **dadurch gekennzeichnet, dass** das Ermitteln des Ausgangssignals umfasst:
Ermitteln eines ersten Vergleichsverlaufs durch Vergleichen des Verlaufs der elektrischen Größe des ersten Halbleiterschalters (34a) mit einem Verlauf eines Mittelwerts aus dem Verlauf der elektrischen Größe des ersten Halbleiterschalters (34a) und dem Verlauf der elektrischen Größe des zweiten Halbleiterschalters (34b); und
Ermitteln eines zweiten Vergleichsverlaufs durch Vergleichen des Verlaufs der elektrischen Größe des zweiten Halbleiterschalters (34b) mit dem Verlauf des Mittelwerts aus dem Verlauf der elektrischen Größe des ersten Halbleiterschalters (34a) und dem Verlauf der elektrischen Größe des zweiten Halbleiterschalters (34b).

## Claims

1. A system for identifying a non-switching semiconductor switch, wherein the system has:
a first detection component, which is configured to detect a profile of an electrical variable of a first semiconductor switch (34a), controlled by means of a first control signal;
a second detection component, which is configured to detect a profile of an electrical variable of a second semiconductor switch (34b), controlled by means of a second control signal and connected in parallel with the first semiconductor switch (34a);
a determination unit, which is configured, based on the profile of the electrical variable of the first semiconductor switch (34a) and the profile of the electrical variable of the second semiconductor switch (34b) to determine an output signal, which allows an identification of a non-switching semiconductor switch of the first semiconductor switch (34a) and/or of the second semiconductor switch (34b),
**characterised in that** the determination unit has:
a first comparison component, which is configured to determine a first comparison profile by comparing the profile of the electrical variable of the first semiconductor switch (34a) with a profile of an average of the profile of the electrical variable of the first semiconductor switch (34a) and the profile of the electrical variable of the second semiconductor switch (34b); and
a second comparison component, which is configured to determine a second comparison profile by comparing the profile of the electrical variable of the second semiconductor switch (34b) with the profile of the average of the profile of the electrical variable of the first semiconductor switch (34a) and the profile of the electrical variable of the second semiconductor switch (34b).

2. The system according to claim 1, wherein
the first detection component has a first measuring amplifier (66a) or is configured as a first measuring amplifier (66a), wherein the first measuring amplifier (66a) is configured, for example, to determine as the profile of the electrical variable of the first semiconductor switch (34a) a profile of an electric current through a first current sense resistor (64a), connected in series with the first semiconductor switch (34a); and/or
the second detection component has a second measuring amplifier (66b) or is configured as a second measuring amplifier (66b), wherein the second measuring amplifier (66b) is configured, for example, to determine as the profile of the electrical variable of the second semiconductor switch (34b) a profile of an electric current through a second current sense resistor (64b), connected in series with the second semiconductor switch (34b).

3. The system according to claim 1 or 2, wherein the output signal, determined by the determination unit, allows a fault in the switching of the first semiconductor switch (34a) and/or of the second semiconductor switch (34b) from a closed state into an open state to be identified.

4. The system according to any one of claims 1 to 3, wherein the system further has an identification component, which is configured to identify the fault in the switching of the first semiconductor switch (34a) and/or of the second semiconductor switch (34b) on the basis of the output signal.

5. The system according to any one of claims 1 to 4, wherein the system further has a delay element, which is configured to determine a fault signal by combining the output signal with a switch-on delay.

6. The system according to any one of claims 1 to 5, wherein
the first comparison component has a comparator (70a) or is configured as a comparator (70a); and/or
the second comparison component has a comparator (70b) or is configured as a comparator (70b).

7. The system according to any one of claims 1 to 6, wherein the determination unit has:
a first logic component, which is configured to determine a first logic signal by combining the first comparison profile with the first control signal;
a second logic component, which is configured to determine a second logic signal by combining the second comparison profile with the second control signal;
a third logic component, which is configured to determine the output signal by combining the first logic signal with the second logic signal.

8. The system according to claim 7, wherein
the first logic component is configured as an XOR gate (72a); and/or
the second logic component is configured as an XOR gate (72b); and/or
the third logic component is configured as an OR gate (74).

9. The system according to any one of claims 1 to 8, wherein the first semiconductor switch (34a) and/or the second semiconductor switch (34b) is/are configured as a power semiconductor; and/or wherein the system has:
the first semiconductor switch (34a); and/or
the second semiconductor switch (34b), connected in parallel with the first semiconductor switch (34a); and/or
at least a third semiconductor switch, connected in parallel with the first and second semiconductor switches.

10. A method for identifying a non-switching semiconductor switch, wherein the method comprises:
detecting a profile of an electrical variable of a first semiconductor switch (34a), controlled by means of a first control signal;
detecting a profile of an electrical variable of a second semiconductor switch (34b), controlled by means of a second control signal and connected in parallel with the first semiconductor switch (34a);
determining an output signal on the basis of the profile of the electrical variable of the first semiconductor switch (34a) and the profile of the electrical variable of the second semiconductor switch (34b), wherein the output signal allows the identification of a non-switching semiconductor switch of the first semiconductor switch (34a) and/or of the second semiconductor switch (34b),
**characterised in that** the determining an output signal comprises:
determining a first comparison profile by comparing the profile of the electrical variable of the first semiconductor switch (34a) with a profile of an average of the profile of the electrical variable of the first semiconductor switch (34a) and the profile of the electrical variable of the second semiconductor switch (34b); and
determining a second comparison profile by comparing the profile of the electrical variable of the second semiconductor switch (34b) with the profile of the average of the profile of the electrical variable of the first semiconductor switch (34a) and the profile of the electrical variable of the second semiconductor switch (34b).

## Revendications

1. Système, destiné à l'identification d'un commutateur à semi-conducteurs non commutant, le système comportant :
un premier composant d'acquisition qui est configuré pour acquérir une courbe d'une grandeur électrique d'un premier commutateur (34a) à semi-conducteurs commandé au moyen d'un premier signal de commande ;
un second composant d'acquisition qui est configuré pour acquérir une courbe d'une grandeur électrique d'un second commutateur (34b) à semi-conducteurs commandé au moyen d'un second signal de commande et connecté en parallèle au premier commutateur (34a) à semi-conducteurs ;
une unité de détermination qui est configurée pour déterminer, sur la base de la courbe de la grandeur électrique du premier commutateur (34a) à semi-conducteurs et de la courbe de la grandeur électrique du second commutateur (34b) à semi-conducteurs, un signal de sortie qui permet une identification d'un commutateur à semi-conducteurs non commutant du premier commutateur (34a) à semi-conducteurs et/ou du second commutateur (34b) à semi-conducteurs,
**caractérisé en ce que** l'unité de détermination comporte :
un premier composant de comparaison qui est configuré pour déterminer une première courbe de comparaison par comparaison de la courbe de la grandeur électrique du premier commutateur (34a) à semi-conducteurs avec une courbe d'une moyenne de la courbe de la grandeur électrique du premier commutateur (34a) à semi-conducteurs et de la courbe de la grandeur électrique du second commutateur (34b) à semi-conducteurs ; et
un second composant de comparaison qui est configuré pour déterminer une seconde courbe de comparaison par comparaison de la courbe de la grandeur électrique du second commutateur (34b) à semi-conducteurs avec la courbe de la moyenne de la courbe de la grandeur électrique du premier commutateur (34a) à semi-conducteurs et de la courbe de la grandeur électrique du second commutateur (34b) à semi-conducteurs.

2. Système selon la revendication 1, dans lequel
le premier composant d'acquisition comporte un premier amplificateur de mesure (66a) ou est configuré en tant que premier amplificateur de mesure (66a), le premier amplificateur de mesure (66a) étant configuré par exemple pour déterminer en tant que courbe de la grandeur électrique du premier commutateur (34a) à semi-conducteurs une courbe d'un courant électrique à travers une première résistance (64a) de mesure de courant connectée en série au premier commutateur (34a) à semi-conducteurs ; et/ou
le second composant d'acquisition comporte un second amplificateur de mesure (66b) ou est configuré en tant que second amplificateur de mesure (66b), le second amplificateur de mesure (66b) étant configuré par exemple pour déterminer en tant que courbe de la grandeur électrique du second commutateur (34b) à semi-conducteurs une courbe d'un courant électrique à travers une seconde résistance (64b) de mesure de courant connectée en série au second commutateur (34b) à semi-conducteurs.

3. Système selon la revendication 1 ou 2, dans lequel le signal de sortie déterminé par l'unité de détermination permet une identification d'une erreur lors de la commutation du premier commutateur (34a) à semi-conducteurs et/ou du second commutateur (34b) à semi-conducteurs, d'un état de commutation fermé en un état de commutation ouvert.

4. Système selon l'une quelconque des revendications 1 à 3, dans lequel le système comporte en outre un composant d'identification qui est configuré pour identifier l'erreur lors de la commutation du premier commutateur (34a) à semi-conducteurs et/ou du second commutateur (34b) à semi-conducteurs sur la base du signal de sortie.

5. Système selon l'une quelconque des revendications 1 à 4, dans lequel le système comporte en outre un dispositif de temporisation qui est configuré pour déterminer un signal d'erreur par combinaison du signal de sortie avec une temporisation de mise en circuit.

6. Système selon l'une quelconque des revendications 1 à 5, dans lequel
le premier composant de comparaison comporte un comparateur (70a) ou est configuré en tant que comparateur (70a) ; et/ou
le second composant de comparaison comporte un comparateur (70b) ou est configuré en tant que comparateur (70b).

7. Système selon l'une quelconque des revendications 1 à 6, dans lequel l'unité de détermination comporte :
un premier composant de jonction qui est configuré pour déterminer un premier signal de jonction par jonction de la première courbe de comparaison avec le premier signal de commande ;
un second composant de jonction qui est configuré pour déterminer un second signal de jonction par jonction de la seconde courbe de comparaison avec le second signal de commande ;
un troisième composant de jonction qui est configuré pour déterminer le signal de sortie par jonction du premier signal de jonction avec le second signal de jonction.

8. Système selon la revendication 7, dans lequel
le premier composant de jonction est configuré en tant que porte XOR (72a) ; et/ou
le second composant de jonction est configuré en tant que porte XOR (72b) ; et/ou
le troisième composant de jonction est configuré en tant que porte OU (74).

9. Système selon l'une quelconque des revendications 1 à 8, dans lequel le premier commutateur (34a) à semi-conducteurs et/ou le second commutateur (34b) à semi-conducteurs et/sont configuré(s) en tant que semi-conducteurs de puissance ; et/ou dans lequel le système comporte :
le premier commutateur (34a) à semi-conducteurs ; et/ou
le second commutateur (34b) à semi-conducteurs connecté en parallèle au premier commutateur (34a) à semi-conducteurs ; et/ou
au moins un troisième commutateur à semi-conducteurs connecté en parallèle au premier et au second commutateur à semi-conducteurs.

10. Procédé pour l'identification d'un commutateur à semi-conducteurs non commutant, le procédé comprenant :
l'acquisition d'une courbe d'une grandeur électrique d'un premier commutateur (34a) à semi-conducteurs commandé au moyen d'un premier signal de commande ;
l'acquisition d'une courbe d'une grandeur électrique d'un second commutateur (34b) à semi-conducteurs commandé au moyen d'un second signal de commande et connecté en parallèle au premier commutateur (34a) à semi-conducteurs ;
la détermination d'un signal de sortie sur la base de la courbe de la grandeur électrique du premier commutateur (34a) à semi-conducteurs et de la courbe de la grandeur électrique du second commutateur (34b) à semi-conducteurs, le signal de sortie permettant l'identification d'un commutateur à semi-conducteurs non commutant du premier commutateur (34a) à semi-conducteurs et/ou du second commutateur (34b) à semi-conducteurs,
**caractérisé en ce que** la détermination du signal de sortie comprend :
la détermination d'une première courbe de comparaison par comparaison de la courbe de la grandeur électrique du premier commutateur (34a) à semi-conducteurs avec une courbe d'une moyenne de la courbe de la grandeur électrique du premier commutateur (34a) à semi-conducteurs et de la courbe de la grandeur électrique du second commutateur (34b) à semi-conducteurs ; et
la détermination d'une seconde courbe de comparaison par comparaison de la courbe de la grandeur électrique du second commutateur (34b) à semi-conducteurs avec la courbe de la moyenne de la courbe de la grandeur électrique du premier commutateur (34a) à semi-conducteurs et de la courbe de la grandeur électrique du second commutateur (34b) à semi-conducteurs.
